# EUROPEAN PATENT APPLICATION

(11) **EP 3 565 009 A1**
(43) Date of publication of application: **06.11.2019**
(21) Application number: 17886407.0
(22) Date of filing: 29.09.2017
(51) Int. Cl.: H01L 31/18

(54) **METHOD OF MOUNTING A MULTI-ELEMENT MATRIX PHOTODETECTOR**

(30) Priority: 29.12.2016 RU 2016152342
(71) Applicant: Limited Liability Company "Scientific - Technical Center - MT" ("STC-MT" LLC), Moscow, 121205 (RU); MEDICAL TECHNOLOGIES LTD (MTL), Moscow, 105118 (RU)
(72) Inventor: SPORYSH, Vladimir Igorevich, Moscow 119334 (RU); PUTILIN, Andrei Nikolaevich, Moscow 109462 (RU); DABAGOV, Anatoly Rudolfovich, Moscow 105264 (RU); BARINOV, Anatoly Andreevich, Moscow 117535 (RU); SUPONNIKOV, Dmitry Alexandrovich, Moscow 121552 (RU)
(74) Representative: Berggren Oy, Helsinki & Oulu
(86) International application number: PCT/RU2017/050096
(87) International publication number: WO 2018/124945

(57) **Abstract**

The proposed invention relates to the manufacturing of devices for detecting a visible or X-ray image or an image obtained when recording X-ray or gamma radiation, in particular devices for X-ray mammography and tomosynthesis. In a new method of mounting a multi-element matrix photodetector of visible or penetrating radiation, at least one matrix photoreceiver is positioned in a controllable manner by means of rotation and movement over the liquid phase of an optical polymer pre-applied to at least a part of a surface of a fiber-optic plate, and is subsequently fixed by curing of said polymer. In the process, there is no physical contact or touching of the surfaces of the photoreceiver and of the fiber-optic plate, which minimizes the probability of a photoreceiver chip being damaged.

## Description

### FIELD OF THE INVENTION

The proposed invention relates to the manufacturing of devices for detecting a visible or X-ray image or an image obtained when recording X-ray or gamma radiation, in particular devices for X-ray mammography and tomosynthesis.

### BACKGROUND OF THE INVENTION

To design digital matrix image sensors, X-ray detectors, including in mammography, the so-called "flat panel" photo sensors are used that record the visible radiation or the converted x-ray image ("shadow") of the object under study. Such flat panel detectors are a full-size spatial (matrix) image sensor with a 1:1 conversion scale.

The photodetector itself features high sensitivity in the visible wavelength range (400-700 nm), but it is generally insensitive to X-rays. Accordingly, scintillation screens (scintillators), which are based on phosphor coatings of various efficiencies and scattering characteristics, are used to convert the X-rays into visible light. Such a screen (scintillator) is physically applied to a fiber-optic plate (FOP) transferring light from the scintillator to the photosensor (photoreceiver) on the one hand as well as blocking X-ray radiation not absorbed in the phosphor layer on the other hand. Scintillator, FOP and photoreceiver form an "X-ray image - electrical signal" transformation stack. In turn, the signal is digitized and transmitted for processing and visualization. Screens of a similar design are used in detectors to detect gamma radiation also.

In the prior art there is known a method of mounting a multi-chip photoreceiver on an optical baseplate, using a carrier metal frame, adapted to subsequent transfer of said matrix photoreceiver to a fiber-optic plate (RF patent 136639 "matrix photoreceiver assembly device"). The disadvantage of this method is the high probability of damage to photoreceivers during butting manipulations, since their active surface is in direct contact with the rigid base plate. Besides, an additional series of alignment installation procedures is required to install the FOP, and this increases the cost and complexity of the process.

The method described in WO 2012-145038 A1 (Teledyne Rad-Icon Imaging Corp.) is selected as the second closest analogue.

The disadvantage of this method is the need to use the applied fixture as the final structural part of the matrix of photoreceivers to be assembled. The number of assembly parts and the cost of the product increase as a result. Additionally, operations of high-precision installation of the matrix on the FOP and combining with it are still required.

Additionally, close analogues of the proposed method can be the installation developed by the authors of a research group consisting of Travis Lange, Tim Bond, James Chiang, Andrew P. Rasmussen and colleagues, and mentioned in the publication «Integration and Verification Testing of the Large Synoptic Survey Telescope Camera» by "SLAC National Accelerator Laboratory, MenloPark, CA, United States. The obvious disadvantage of the method used in the described equipment is the high complexity and bulkiness of the combination and alignment system as well as the considerable slowness of the process, which makes it suitable for non-mass production only. Additionally, the parts fixed on the photoreceivers increase significantly the overall height and weight of the final design.

### SUMMARY OF THE INVENTION

The proposed method is aimed at simplifying the assembling of a multi-chip detector which provides a large percentage of usable detectors as an output of the production process.

The object of assembling is a mutual alignment of the photoreceivers relative to the FOP and, at the same time, mutual alignment them relative to each other. In particular, one of the essential requirements when assembling the matrix of photoreceivers is to ensure as small as possible gap between the photoreceivers. The lower limit of the gap size is determined by the requirements for the temperature range at which the assembled matrix is stored and operated because no physical collision of silicon wafers of individual photoreceivers should occur with a possible decrease in temperature. Such a collision can lead to mechanical damage to the silicon chips and the failure of photoreceivers.

The upper limit of the gap size is defined by the object of restoring the integrity of the image in the docking area of the photoreceivers and, as a rule, is limited by a value of 1-2 photoreceiver cell pitches (pixel).

Thus, the process of aligning the photoreceivers shall be controlled very strictly and carefully to assemble highly accurately. For real photoreceivers with a pixel size/pixel pitch of 50-100 µm, the required accuracy of photoreceiver positioning is estimated at 5-10 µm, that is, an order of magnitude higher than the pixel pitch.

The technical result achieved in the implementation of the proposed method is the reduced mechanical impact on matrix photoreceivers during the assembly process, simplified installation technology and the reduced weight of the assembled matrix detector, as well as the improved manufacturability and expanded scope of application.

To solve the task and achieve the claimed technical result, a method is proposed wherein the FOP is an assembly surface and, at the same time, a leveling surface for the so-called optical plane, which is a matrix of several chips of photoreceiver. Thus, in fact, one of the structural parts of the detector serves as an assembly tool, which shortens the assembly process.

The object and the required technical result are achieved through the new method of mounting a multi-part scintillation penetrating radiation detector, wherein at least one matrix photoreceiver is contact-free adjusted, rotated and moved along the liquid phase of the optical polymer that is pre-deposited on at least a part of the fiber surface optical plate, followed by fixation due to the curing of the specified polymer; wherein at the stages of adjustment, rotation and displacement, hydroplaning is used to prevent mechanical impact on the matrix photoreceiver; while at the stage of moving the matrix photoreceiver, its electronic circuit can be connected to the electronic units of the data reading system. According to the proposed method, at least one image of the test object can be projected on the outer side of the fiber-optic plate opposite to the polymer side in order to accurately monitor the position of the matrix photoreceiver during installation. In the process of moving the matrix photoreceiver, its position is controlled by the image on the outer side of the fiber-optic plate opposite to the polymer side.

According to the proposed method, structural elements that direct and limit the movement of a matrix photoreceiver are preliminarily formed on the surface of a fiber-optic plate, for example, by 3D lithography in polymerizing fluids. The formed structural elements direct and limit the displacement of the matrix photoreceiver not only in the displacement plane but also in the direction perpendicular to said plane.

To prevent mechanical contact on the matrix photoreceiver at the stages of adjustment, rotation and displacement, electromagnetic linear positioning motors without mechanical connection of the rotor and stator are used.

According to the proposed method, in one embodiment, a silicon substrate-free chip is used as a matrix photoreceiver.

According to the proposed method, contact connections and external circuits of the specified silicon substrate-free chip are mounted on the specified fiber-optic plate after installation.

The FOP surface is the surface which the most dense optical contact of the matrix photoreceiver shall be provided with, in order to ensure maximum contrast and resolution of images acquired by scintillation photoreceivers. Thus, direct mounting on a specified surface would be the most natural method of mounting, but in this case a number of mounting operations are difficult to perform; to minimize mechanical impact on the matrix photoreceiver, special separation and supporting column elements are proposed to be used that are pre-applied to the FOP, wherein these elements are made by 3D lithography (stereolithography) method. In the preferred embodiment, a photosensitive detector will comprise a minimum of structural elements, namely: a fiber-optic plate, silicon chips of photoreceivers and peripheral interface nodes representing the chip wiring area and PCBs with readout circuits and electrical connectors for transferring image data to processing circuits.

The liquid polymer applied to the surface of the FOP before the start of assembly, which cures further in the process, serves simultaneously for several purposes: it protects the surface of the photoreceivers from direct contact with the FOP; it implements optical immersion to minimize light loss at the edges of materials; it is the antifriction medium that facilitates greatly moving the photoreceiver chips relative to the FOP. Also the said polymer creates a durable adhesive interface between the FOP and the surface of the photoreceiver to form a highly stable structure, because the temperature coefficients of expansion of silicon and glass that make up the main material of the FOP are very close.

The scope is expanded due to the final fixation of the photoreceiver chips directly to the FOP and since the fiber-optic plate has the thermal expansion coefficient (TEC) comparable to that of silicon which is the material of the photoreceiver chip, the allowable temperature range of operation and storage of the manufactured product increases. In addition, the overall dimensions of the product are reduced, since the alignment elements are no longer needed to be left in the assembled structure.

### BRIEF DESCRIPTION OF THE DRAWINGS

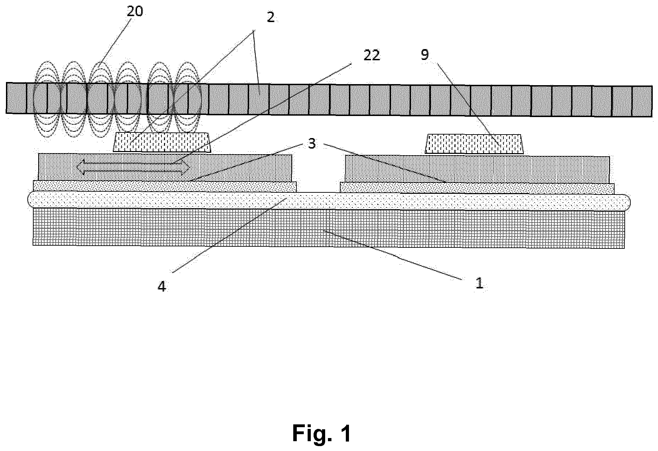

Fig. FIG. 1 shows a cross-section of the equipment that aligns photoreceivers (3) located on an immersion layer of the liquid polymer (hereinafter referred to as an "immersion-adhesive layer") (4) applied to FOP (1). The photoreceivers are moved using a linear stepping system (2) consisting of coils forming a multi-phase magnetic field (20) and acting on permanent magnets (9) fixed (temporarily) on the reverse side of the photoreceivers. This impact results in moving the photoreceivers (22) to necessarily align.

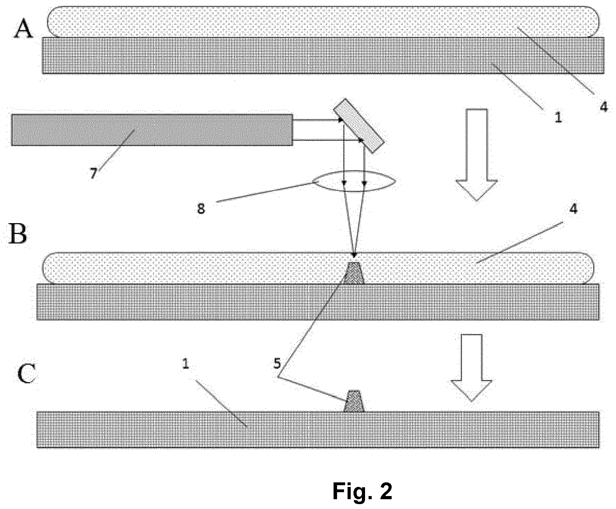

Fig. 2 shows the stages of the formation of separation (barrier) and support columns on the surface of the FOP:
   A) the liquid photopolymer (4) is poured on the surface of the FOP (1);
   B) a laser (7) and a projection system (8) are used to form columnar or hemispherical sections (5) that get cured in the bulk of the photopolymer (4);
   C) the uncured polymer is optionally removed from the FOP (1) and the formed barrier columns (5) remain on the surface.

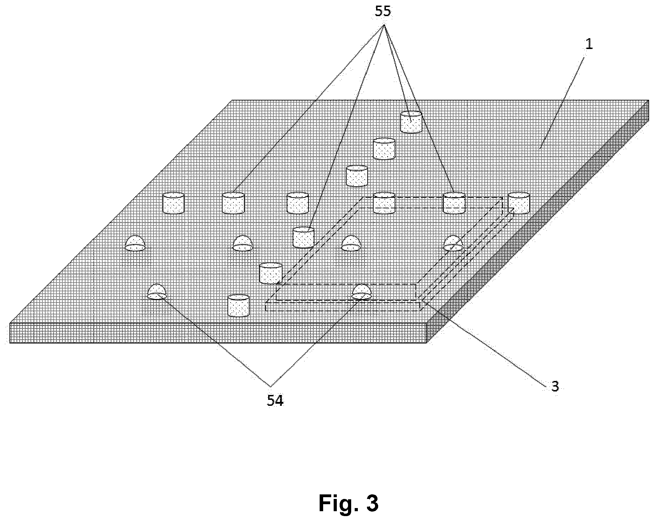

Fig. 3 shows schematically the matrix of barrier columns (55) and the matrix of supporting hemispheres (54) which are also formed by photo-curing the polymer or direct printing with a polymeric material on the surface of the FOP (1). The photoreceiver (3) is located on the support hemispheres, thereby eliminating direct contact between the surfaces of the photoreceiver and the FOP.

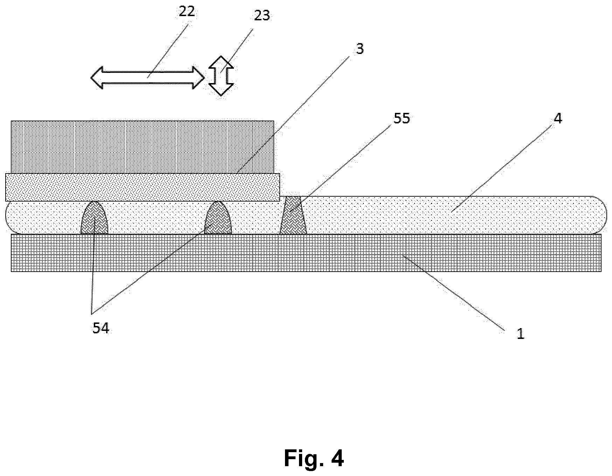

Fig. 4 shows schematically the process of moving the photoreceiver (3) along the axes X (22) and Y (23) in the process of aligning. The photoreceiver slides over the liquid polymer 4 (that gets cured subsequently), while the supporting hemispheres (54) provide a constant small gap between the FOP (1) and the silicon photoreceiver chip (3).

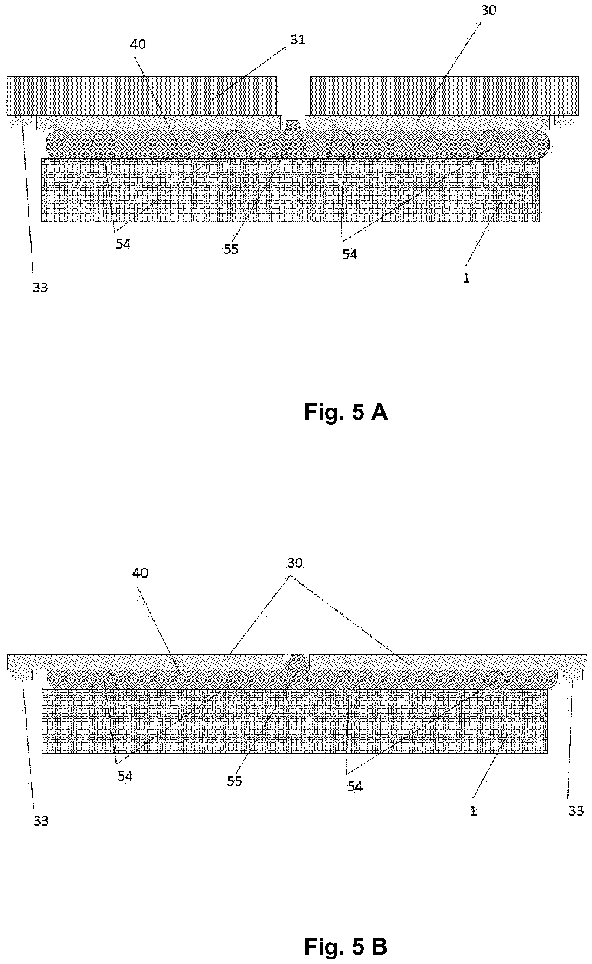

Fig. 5 shows the options for aligning photoreceivers with and without a substrate:
   A) the silicon photoreceiver chip (30) with a substrate (31), which is glued onto the FOP (1) through the polymer (40) that has been pre-applied and then cured. The area of photoreceiver chip bondpads wiring (33) is shown for reference;
   B) a substrate-free silicon photoreceiver chip (30) is glued onto the FOP (1) with polymer (40) pre-applied and then cured, as well as supporting hemispheres (54) and bounding columns (55) are shown, which are formed in the liquid polymer (before its main volume gets cured) and which fix the distance between the surfaces of the silicon chips and the FOP and their edges.

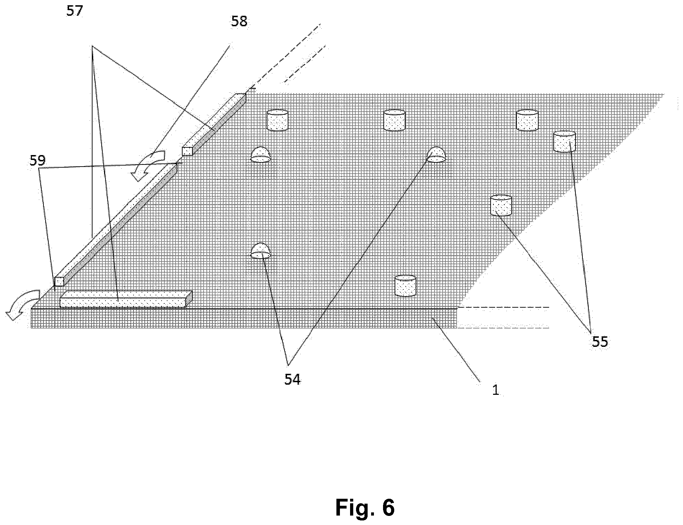

Fig. 6 shows a part of the FOP (1) with a barrier of columns (55), with a matrix of supporting hemispheres (54) and structures formed on the surface of the FOP that allow to remove excess liquid polymer under control, wherein:
   57 - boards formed on the surface of the FOP;
   58 - polymer excess drain;
   59 - channels between the boards to remove polymer excess;

### DETAILED DESCRIPTION OF THE INVENTION

The matrix photodetector comprises at least one photoreceiver (3) located on the FOP (1) and fixed with the help of a polymerized (40) liquid optical polymer (4). Description of the method distinguishes the phases of the polymer when indicated by numbers on the figures. In the context of this description, N (4) states to indicate the liquid phase of the polymer, and N (40) - for the cured phase.

Initially, the liquid polymer is distributed over the FOP area evenly or partially, and then the photoreceiver or several photoreceivers are placed on the surface formed by the polymer. A partial distribution of a polymer is understood to be applied in the required volume on a part of the surface rather than the entire surface, usually in the shape of a drop, oval or dumbbell. In the case of partial distribution of the polymer on the FOP, the polymer spreads over the entire area of the FOP due to the compression forces and the capillary effect. At this stage, photoreceivers can be placed on the FOP with relatively low accuracy.

The described stage is preceded by the preparation of the FOP surface during which the separating row of columns (55) is formed from a polymer that prevents collisions of photoreceiver chips when they are being aligned, and allows to provide the necessary gap that is sufficiently large to prevent adjacent chips which are already fixed on a common base from mutual contacting during thermal expansion. Such columns can be formed with a multi-pass printing, for example, with a siloxane polymer, followed by its curing. Positioning-micro-dosing-printing systems are widespread in a range of choices. These systems work with fluids of various viscosities and allow forming the described column structures with a size of 100 µm and with an accuracy of up to 5 µm. Thus, for example, a corresponding gap of 100 µm can be provided between silicon chips of photoreceivers being aligned. If greater accuracy is required, then the method of forming cured structures in the photopolymer layer applied to the surface of the FOP is most suitable according to the described method. The same photopolymer serves as an immersion-adhesive layer between the FOP and the silicon photoreceiver chip. To align and support silicon chips along the FOP plane, another type of microstructure is used, namely, the matrix of supporting hemispheres (54), which is formed in a technology similar to columns (55). Their size, location on the FOP and shape are selected to provide a minimal mechanical contact of the silicon chip with the FOP surface and can be optimized for a particular chip taking into account the features of the chip profile and its deflections. The prototype of the use of supporting hemispheres is the use of microspheres in the production technology of LCD displays where the microspheres provide uniform mutual distancing of glass plates.

To perform precise movement of photoreceivers "floating" on liquid polymer (4), a so-called linear-spatial stepping motor is proposed to be used, the stator of which is a matrix of electromagnets with differentiated phase and current control in the windings, and the rotor are permanent magnets temporarily fixed on the reverse side of the photoreceivers.

Other methods of moving photoreceivers during the process of aligning, for example using micromechanical actuators, are also possible.

The process of moving photoreceivers can be controlled using high-magnification video cameras located under the bottom side of the FOP. In any case, the errors of the system of displacement of the photoreceivers are, however, compensated by restricting their movement in contact with the dividing rows of columns (55). This means that the positioning / moving system of photoreceivers (linear spatial stepping motor) must have small shear forces of moving objects (photoreceivers) wherein case the photoreceiver should stop when it abuts on the separation row and do not move further even if the forces of its displacement continue.

The number, shape and interposition of structural elements (54, 55) can be any, while they should be, however, sufficient to ensure a constant small gap between the FOP (1) and silicon photoreceiver chip (3) and, at the same time, to limit the movement of the chips during their movement and positioning.

After positioning all photoreceivers or each photoreceiver separately, the immersion-adhesive layer (on which the photoreceiver slid while moving) is cured. The most accessible and simple method for this is the use of a photo-curable polymer as an immersion-adhesive layer (4) which also serves as an anti-friction layer when aligning photoreceivers. Similarly, epoxy adhesive and gel polymer compositions or thermosetting compositions can be used if their curing temperature does not significantly affect the performance of the assembly after curing. The photocurable polymer is cured by exposing it to UV radiation directed through the bottom surface of the FOP. Epoxy or siloxane compositions cure without additional external influences through the normalized time of assembly in the range of specified temperatures and time (usually 12-28 hours at 20-40°C).

After curing the immersion-adhesive layer (of photopolymer or other optically transparent composition), the assembled matrix of photoreceivers is ready for operation.

## Claims

1. A method of mounting a multi-element matrix photodetector, wherein at least one matrix photoreceiver is contact-free adjusted, rotated and moved over the liquid phase of the optical polymer that is pre-deposited on at least a part of the surface of the fiber-optic plate, followed by fixation due to the curing of the said polymer.

2. The method according to claim 1, wherein at the stages of adjustment, rotation and displacement, hydroplaning is used to prevent mechanical impact on the matrix photoreceiver.

3. The method according to claim 1, wherein at the stage of moving the matrix photoreceiver, its electronic circuit can be connected to the electronic units of the data reading system.

4. The method according to claim 3, wherein at least one image of the test object is projected on the outer side of the fiber-optic plate opposite to the polymer side in order to accurately monitor the position of the matrix photoreceiver during installation.

5. The method according to claim 1, wherein structural elements that direct and limit the movement of a matrix photoreceiver are preliminarily formed on the surface of a fiber-optic plate.

6. The method according to claim 5, wherein the said structural elements are formed by 3D lithography in polymerizing fluids.

7. The method according to claim 1 and claim 2, wherein electromagnetic linear positioning motors without mechanical contact of the rotor and stator are used to prevent mechanical impact on the matrix photoreceiver at the stages of adjustment, rotation and displacement.

8. The method according to claim 1, wherein the position of the matrix photoreceiver during the process of its moving is controlled by the image on the reverse side of the fiber-optic plate.

9. The method according to claim 6, wherein the formed structural elements direct and limit the displacement of the matrix photoreceiver not only in the displacement plane but also in the direction perpendicular to this plane.

10. The method according to claim 1, wherein a silicon substrate-free chip is used as a matrix photoreceiver.

11. The method according to claim 10, wherein contact connections and external circuits of the specified silicon substrate-free chip are mounted on the specified fiber-optic plate after installation.
